# EUROPÄISCHE PATENTANMELDUNG

(11) **EP 1 235 111 A2**
(43) Veröffentlichungstag der Anmeldung: **28.08.2002**
(21) Anmeldenummer: 02001170.6
(22) Anmeldetag: 28.01.2002
(51) Int. Cl.: G03F 7/20

(54) **Banding-reduzierende Bebilderung einer Druckform**

(30) Priorität: 22.02.2001 DE 10108624
(71) Anmelder: Heidelberger Druckmaschinen Aktiengesellschaft, 69115 Heidelberg (DE)
(72) Erfinder: Beier, Bernard, Dr., 68526 Ladenburg (DE); Ernst, Uwe, 68163 Mannheim (DE); Vosseler, Bernd, 69120 Heidelberg (DE)

(57) **Zusammenfassung**

Bei einem Verfahren und einer Einrichtung zur Bebilderung einer Druckform (48) durch wenigstens zwei Bebilderungsmodule (40,418), welche jeweils wenigstens eine Lichtquelle aufweisen, ist zur Vermeidung des Banding-Effektes vorgesehen, dass eine Bebilderung in einem Übergangsbereich (416) durch die zwei Bebilderungsmodule (40,418) derart erfolgt, dass die Erzeugung einer Anzahl von wenigstens teilweise nicht-einfachzusammenhängenden Druckpunkten im Übergangsbereich (416) durch das erste Bebilderungsmodul (40) und die Erzeugung der komplementären, nicht-einfachzusammenhängenden Druckpunkte im Übergangsbereich (416) durch das zweite Bebilderungsmodul (418) stattfindet.

## Beschreibung

Die vorliegende Erfindung betrifft allgemein Bilderzeugungsverfahren zum Einsatz in der graphischen Technik, insbesondere in der Drucktechnik oder Vervielfältigungstechnik. Sie betrifft im Besonderen ein Verfahren und eine Einrichtung zur Bebilderung einer Druckform durch wenigstens zwei Bebilderungsmodule gemäß den jeweiligen Oberbegriffen der unabhängigen Ansprüche.

Auf dem Gebiet der graphischen Technik, insbesondere der Offset-Drucktechnik, werden bei der Herstellung von ebenen oder gekrümmten Druckformen durch sogenannte Vielstrahlbebilderung bekanntermaßen Bebilderungsmodule eingesetzt, bei denen eine simultane Belichtung von mehreren Bildpunkten auf verschiedenen Medien, wie Druckplatten, Filmen, Datenträgern oder ähnlichem, erfolgt.

Zur Zeit werden zur Bebilderung von Druckplatten durch Lichtquellen vor allem Laserdiodensysteme eingesetzt, die auf zwei unterschiedlichen Konzepten beruhen. Einerseits kann die Strahlung einzelner Laserdioden oder eines Arrays von Laserdioden über optische Elemente wie Linsen, Spiegel oder Fasern dem zu bebildernden Medium zugeführt werden. Andererseits kann die Strahlung aus einer Laserlichtquelle, typischerweise Laserdiodenbarren, über diverse optische Elemente auf ein Array von n Modulatoren, wobei n eine natürliche Zahl ist, typischerweise elektrooptische oder akustooptische Modulatoren, abgebildet werden. Die einzelne Ansteuerung der n Modulatoren ermöglicht dabei eine Selektion einzelner Strahlen aus der gesamten Strahlung und die Modulation deren Leistung. Solche Laserdiodensysteme gehen beispielsweise aus der EP 0 878 773 A2 und der US 5,521,748 hervor.

Des Weiteren sind sogenannte "Interleafrasterscanlinien-Verfahren" (im Folgenden "IRS-Verfahren") bekannt, bei denen Rasterscanlinien mittels einer Mehrstrahllaserlichtquelle auf ein Medium geschrieben werden. So geht aus der US 5,691,759 ein solches Verfahren hervor, bei dem eine Laserlichtquelle n Bildpunkte, wobei n eine natürliche Zahl ist, mit modulierter Leistung durch entsprechende Abbildungsoptik und Intensitätsmodulation erzeugt. Diese n Bildpunkte sind auf einer Linie, mit anderen Worten liegen in einer Reihe, angeordnet. Nach erfolgtem Bebildern von n Punkten erfolgt eine relative Verschiebung des Mediums zu den Bildpunkten mit einer Translationskomponente senkrecht zu der durch die Achse der Bildpunkte definierten Richtung, so dass an einer anderen Stelle des Mediums erneut n Punkte geschrieben werden können. Typischerweise verläuft die Achse der Bildpunkte im wesentlichen parallel zur Achse eines Zylinders, auf welchem eine zu bebildernde Druckform aufgenommen ist. Durch die Laserstrahlung, deren Leistung entsprechend der jeweiligen Bildinformation moduliert ist, entstehen die genannten Rasterscanlinien von intensitätsmodulierten Bildpunkten. Damit kann eine individuelle Schwärzung verschiedener Druckpunkte erreicht werden.

Es ist bereits hier anzumerken, dass man im eindimensionalen Fall in diesem Zusammenhang unter einer "Zeile von Druckpunkten" eine Linie versteht, welche durch eine anschließende Verschiebung des Bebilderungsmoduls mit einer Anzahl von Lichtquellen, oder alternativ des zu beschreibenden Mediums, also der Druckform, in der durch die Reihe der Bildpunkte des Bebilderungsmoduls definierten Richtung entsteht. Eine Zeile bedeutet demnach auf gleicher Höhe liegende Druckpunkte verschiedener, nebeneinander geschriebener Scanlinien. Eine Verallgemeinerung von IRS-Verfahren auf den zweidimensionalen Fall mit Bildpunkten, welche eine regelmäßige (n₁ x n₂)-Matrix bilden, wobei n₁ und n₂ natürliche Zahlen sind, ist auf einfache Art möglich, indem ein IRS-Verfahren in die durch eine Zeile der Matrix definierten Richtung und ein IRS-Verfahren in die durch eine Spalte der Matrix definierten Richtung durchgeführt wird.

Gemäß der US 5,691,759 erfolgt nach Abschluss eines Scans mit einer Translationskomponente in senkrechter Richtung eine Verschiebung parallel zu der durch die Achse der n Bildpunkte definierten Richtung um eine Strecke. Die n Bildpunkte werden nun erneut mit einer Translationskomponente senkrecht zu der durch die Achse der Bildpunkte definierten Richtung auf der Oberfläche des Mediums verschoben, so dass weitere Scanlinien entstehen. Jede Rasterscanlinie ist also von ihrer direkten Nachbarin durch den Abstand der Druckpunkte räumlich getrennt. In dieser Weise mehrere optische Strahlen einer Laserlichtquelle benutzend, wird demnach eine Überlappung (Interleave) der Scanlinien erreicht.

Ferner offenbart die EP 0 947 950 A2 ein erweitertes IRS-Verfahren, bei dem mittels geeignter Wahl der Schrittweite der Verschiebung parallel zu der durch die Bildpunkte definierten Achse, um die das Medium zwischen den Beschriftungen zweier Scanlinien bewegt wird, eine Überlappung erreicht wird, d.h. neue Scanlinien zwischen bereits geschriebenen Scanlinien geschrieben werden, wobei keine Stelle mehrfach von einem Bildpunkt eines Lasers berührt wird.

Zudem geht aus der vorangemeldeten deutschen Patentanmeldung Nr. DE 100 31 915 ein IRS-Verfahren hervor, bei dem zur Bebilderung von Druckplatten mittels eines Bebilderungsmoduls eine Druckform in einzelnen Rasterscanlinien belichtet wird. Mittels einer Abbildungsoptik werden n Bildpunkte, welche einen Abstand 1 zwischen benachbarten Punkten aufweisen, erzeugt. Es wird ein Interleafverfahren benutzt, welches sich dadurch auszeichnet, dass die Schrittweite der Verschiebung in Richtung der durch die Bildpunkte definierten Achse größer als der Abstand 1 benachbarter Punkte ist.

Um eine schnellere Bebilderung einer Druckform zu erreichen, können bei einem parallelen Einsatz mehrerer Bebilderungsmodule einzelne Gebiete der gesamten zu bebildernden Fläche jeweils von einem zugeordneten Bebilderungsmodul bebildert werden. Dazu wird die zu bebildernde Fläche typischerweise in Streifen unterteilt. Jeder der Streifen wird dabei von einem einzelnen Bebilderungsmodul belichtet. In dem Bereich, in dem jeweils zwei solcher Streifen aneinanderstoßen, werden Justagefehler der beiden bebildernden Bebilderungsmodule zueinander durch die scharfe Kante zwischen den beiden Streifen besonders deutlich, insbesondere bei der hohen Präzisionsanforderung in der graphischen Technik. Sind die beiden Bebilderungsmodule beispielsweise etwas zu weit auseinander angeordnet, entsteht eine Lücke; andernfalls bildet sich eine zu breite Linie heraus. Dieser Effekt ist in der Literatur als "Banding" bekannt.

Zur Verringerung des vorgenannten Banding-Effektes offenbart die US 5,942,745 einen Lösungsansatz, bei dem die scharfe Kante durch eine zerfranste Kante ersetzt wird. Diese zerfranste Kante wird innerhalb eines Übergangsbereichs zwischen zwei benachbarten Gebieten erzeugt, indem zusammenhängende Zeilen von Druckpunkten in diesem Übergangsbereich jeweils in einem ersten Abschnitt von der Grenze zum ersten benachbarten Gebiet bis zu einem Zwischenpunkt durch das dem ersten Gebiet zugeordneten Bebilderungsmodul erzeugt und in einem zweiten Abschnitt vom Zwischenpunkt bis zur Grenze zum zweiten Gebiet durch das dem zweiten Gebiet zugeordneten Bebilderungsmodul erzeugt wird, wobei sich für benachbarte Zeilen, also Zeilen unterschiedlicher Höhe in Richtung parallel zu den Bereichsgrenzen, die Lage der Zwischenpunkte unterschiedlich sein kann.

Des Weiteren offenbaren die US 5,818,498 und die US 5,757,411 Lösungsansätze, bei denen Bildpunkte im Kantenbereich zwischen benachbarten Gebieten jeweils wenigstens zweimal bebildert werden.

Nachteil der beiden vorgenannten Vorgehensweisen, d.h. der Erzeugung einer zerfranzten Kante sowie der Mehrfachbebilderung in einem Übergangsbereich ist, dass die mit einem Bebilderungsmodul zu bebildernde Streifenbreite erheblich zusätzlich vergrößert wird, entweder um Druckpunkte bis zu Zwischenpunkten an verschiedenen Stellen setzen oder um Mehrfachbelichtungen einzelner Druckpunkte ausführen zu können. Das Ziel, eine schnelle Bebilderung durch Einteilung der Druckform in verschiedene Gebiete, welche jeweils von einzelnen Bebilderungsmodulen belichtet werden, zu erreichen, kann dadurch konterkariert werden. Gegebenenfalls sind sogar mehrere Bebilderungsmodule zur Bebilderung der vergrößerten Streifenbreite erforderlich.

Der vorliegenden Erfindung liegt deshalb die Aufgabe zugrunde, ein eingangs erwähntes Verfahren und eine Einrichtung zur Bebilderung einer Druckform zu schaffen, welche die vorgenannten Nachteile des Standes der Technik vermeiden und den genannten "Banding"-Effekt technisch möglichst einfach und daher kostengünstig verringert.

Diese Aufgabe wird durch ein Verfahren und eine Einrichtung mit den Merkmalen der unabhängigen Ansprüche gelöst. Vorteilhafte Weiterbildungen sind Gegenstand der Unteransprüche.

Der Erfindung liegt der Gedanke zugrunde, durch eine besondere Anwendung oder Ausnutzung des oben beschriebenen IRS-Verfahrens und der Schaffung einer zugehörigen Einrichtung den Banding-Effekt zu reduzieren oder sogar völlig zu unterdrücken.
Bei der Bebilderung mit einem IRS-Verfahren entsteht jeweils am Anfang und am Ende des Schreibvorganges einer zusammenhängenden Zeile von Druckpunkten, d. h. von Bebilderungspunkten oder von durch mehrere Bebilderungen erzeugten Druckpunkten, ein Bereich, in dem nur ein Teil der zu setzenden Druckpunkte auf der Druckform bebildert wird. Im folgenden sind diese Bereiche auch als Anfangsrand und Endrand bezeichnet. Typischerweise liegen in einer zusammenhängenden Zeile zu bebildernde Druckpunkte in einem Abstand p benachbarter Punkte, anders ausgedrückt: Punkte im Abstand p liegen dicht. Im Anfangsrand und Endrand liegen nun belichtete also gesetzte und nicht belichtete also nicht gesetzte Druckpunkte. Die belichteten oder gesetzten Druckpunkte bilden dabei eine Menge von Punkten, welche eine nicht-einfachzusammenhängende Topologie aufweisen. Darunter ist in diesem Zusammenhang zu verstehen, dass die Menge der gesetzten Druckpunkte wenigstens einen Punkt umfasst, welcher wenigstens einen direkt benachbarten Punkt in der Zeile aufweist, welcher nicht gesetzt ist. Entsprechend bilden die nicht gesetzten Druckpunkte im Anfangsrand beziehungsweise Endrand eine komplementäre Menge: Die Menge der gesetzten Druckpunkte vereinigt mit der komplementären Menge umfasst alle Druckpunkte im Anfangsrand beziehungsweise Endrand. Die Punkte der Vereinigungsmenge liegen dann dicht.

Das erfindungsgemäße Verfahren zur Bebildung einer Druckform durch wenigstens ein erstes Bebilderungsmodul und ein zweites Bebilderungsmodul zur Erzeugung von Druckpunkten auf der Druckform, wobei beide Bebilderungsmodule zur Bebilderung in einem Übergangsbereich gleiche Orte der Druckform überstreichen, zeichnet sich dadurch aus, dass im Übergangsbereich eine Anzahl von wenigstens teilweise nicht-einfachzusammenhängenden Druckpunkten durch das erste Bebilderungsmodul und Erzeugung der komplementären, nicht-einfachzusammenhängenden Druckpunkte durch das zweite Bebilderungsmodul erzeugt werden.

In vorteilhafter Ausführungsform weist das erfindungsgemäße Verfahren zur Bebildung einer Druckform durch wenigstens zwei Bebilderungsmodule - im allgemeinen Fall m Bebilderungsmodule, wobei m eine natürliche Zahl ist -, welche jeweils wenigstens eine, vorzugsweise eine Anzahl von Lichtquellen aufweisen, zur Erzeugung von Druckpunkten, typischerweise im Abstand p zweier benachbarter Druckpunkte, auf der Druckform dabei die folgenden Schritte auf. Es wird eine Einteilung der Druckform in m vorzugsweise einfachzusammenhängende, streifenförmige Gebiete mit (m-1) Übergangsbereichen, wobei jedem der m Gebiete ein Bebilderungsmodul und jedem der (m-1) Übergangsbereiche die zwei Bebilderungsmodule der zwei angrenzenden Gebiete zugeordnet sind, vorgenommen. Durch geeignete Aktuatorik, durch einen Servomotor oder dergleichen, wird eine Relativbewegung zwischen den Bebilderungsmodulen und der Druckform derart erzeugt, dass die Orte der zu erzeugenden Druckpunkte wenigstens einmal von einem Bildpunkt einer Lichtquelle in einem Bebilderungsmodul überstrichen werden. Die erwähnte Einteilung der Druckform kann beispielsweise durch die Amplituden der Bewegung der Bebilderungsmodule bestimmt sein, ohne dass konkret auf der Druckform Gebiete festgelegt werden. Es erfolgt also eine Belichtung der Druckform in jedem der m Gebiete durch das ihm zugeordnete Bebilderungsmodul mit vorzugsweise linienförmig angeordneten Bildpunkten der Lichtquelle des Bebilderungsmoduls und eine Belichtung der Druckform in jedem der (m-1) Übergangsbereiche durch die zwei Bebilderungsmodule der angrenzenden zwei Gebiete mit vorzugsweise linienförmig angeordneten Bildpunkten der Lichtquellen der Bebilderungsmodule. Das erfindungsgemäße Verfahren zur Bebildung einer Druckform zeichnet sich dadurch aus, dass wenigstens in einem Übergangsbereich eine Anzahl von wenigstens teilweise nicht-einfachzusammenhängenden Druckpunkten durch das Bebilderungsmodul des ersten angrenzenden Gebietes und komplementäre, nicht-einfachzusammenhängende Druckpunkte durch das Bebilderungsmodul des zweiten angrenzenden Gebietes erzeugt werden.

Besonders vorteilhaft für den Einsatz des erfindungsgemäßen Verfahrens ist es, eine Einteilung der Druckform in m ähnliche einfachzusammenhängende Gebiete und (m-1) ähnliche Übergangsbereiche, welche eine äquivalente Geometrie aufweisen, vorzunehmen. Unter ähnlichen Gebieten bzw. Übergangsbereichen mit äquivalenter Geometrie ist in diesem Zusammenhang zu verstehen, dass die einfachzusammenhängenden Gebiete dieselbe Anzahl von Druckpunkten und eine äquivalente Verteilung in der Fläche der Druckform aufspannenden Koordinatenrichtungen aufweisen. Unter ähnlichen Übergangsbereichen mit äquivalenter Geometrie ist zu verstehen, dass diese ebenfalls dieselbe Anzahl von Druckpunkten mit entsprechender Verteilung in die beiden die Fläche der Druckform aufspannenden Koordinatenrichtungen aufweisen.

Mit besonderem Vorteil werden Bebilderungsmodule eingesetzt, welche n Lichtquellen mit n aus den natürlichen Zahlen aufweisen, deren Bildpunkte auf der Druckform einen Abstand 1 zwischen benachbarten Bildpunkten aufweisen, wobei 1 ein Vielfaches des Abstandes p zweier benachbarter Druckpunkte ist. Es ist vorteilhaft, eine Belichtung der Druckform durch jedes Bebilderungsmodul in dem diesem zugeordneten Gebiet und dem ihm zugeordneten Übergangsbereich oder ihm zugeordneten Übergangsbereichen mit einem Interleafverfahren durchzuführen. In einem derartigen Interleafverfahren gilt bevorzugt, dass die Translationsstrecke t und der Abstand 1 benachbarter Bildpunkte, beide gemessen in Einheiten des Abstandes benachbarter Druckpunkte p, teilerfremde natürliche Zahlen sind. Bevorzugt ist dabei die Verwendung eines Inteleafverfahrens mit einer Schrittweite um die Translationsstrecke t, welche gleich der Anzahl n der Lichtquellen in jedem der m Bebilderungsmodule ist. Die Schrittweite um die Translationsstrecke t ist dabei größer als der Abstand 1 benachbarter Bildpunkte.

Die erfindungsgemäße Einrichtung zur Bebildung einer Druckform durch wenigstens zwei Bebilderungsmodule, welche relativ zu der Druckform bewegbar sind, wobei die Bewegung des ersten Bebilderungsmodul die Bildpunkte wenigstens einer Lichtquelle und die Bewegung des zweiten Bebilderungsmoduls die Bildpunkte wenigstens einer Lichtquelle über einen Übergangsbereich der Druckform führt, so dass Druckpunkte durch eine einmalige Passage eines Bildpunktes einer Lichtquelle erzeugt werden, zeichnet sich dadurch aus, dass die Bildpunkte der Lichtquellen des ersten Bebilderungsmoduls im Übergangsbereich eine Menge von Druckpunkten erzeugen, welche eine nicht-einfachzusammenhängende Menge bilden, und die Bildpunkte der Lichtquellen des zweiten Bebilderungsmoduls im Übergangsbereich die komplementäre, nicht-einfachzusammenhängende Menge von Druckpunkten erzeugen.

In vorteilhafter Ausführungsform weist die erfindungsgemäße Einrichtung zur Bebildung einer Druckform wenigstens zwei Bebilderungsmodule auf, welche relativ zu der Druckform bewegbar sind und jeweils wenigstens eine Lichtquelle, bevorzugt eine Anzahl einzelner Lichtquellen umfassen. Die Bewegung des ersten Bebilderungsmoduls führt die Bildpunkte der Lichtquellen des ersten Bebilderungsmoduls über einen ersten Bereich und einen Übergangsbereich der Druckform, und die Bewegung des zweiten Bebilderungsmoduls führt die Bildpunkte der Lichtquellen des zweiten Bebilderungsmoduls über einen zweiten Bereich und den Übergangsbereich der Druckform. Druckpunkte werden durch das erste Bebilderungsmodul in den ersten Bereich und den Übergangsbereich und durch das zweite Bebilderungsmodul in den zweiten Bereich und in den Übergangsbereich derart gesetzt, dass ein Druckpunkt durch eine einmalige Passage eines Bildpunktes einer Lichtquelle erzeugbar ist. Die erfindungsgemäße Einrichtung zeichnet sich dadurch aus, dass die Bildpunkte der Lichtquellen des ersten Bebilderungsmoduls im Übergangsbereich eine Menge von Druckpunkten erzeugen, welche eine nicht-einfachzusammenhängende Menge bilden, und die Bildpunkte der Lichtquellen des zweiten Bebilderungsmoduls im Übergangsbereich die komplementäre nicht-einfachzusammenhängende Menge von Druckpunkten erzeugen. Eine Verallgemeinerung auf m Gebiete und (m-1) Übergangsbereiche ist für den Fachmann offensichtlich.

Mit besonderem Vorteil weist jedes Bebilderungsmodul n Lichtquellen auf, welche im wesentlichen auf einer Linie mit einem Abstand 1 zwischen benachbarten Lichtquellen liegen.

Gemäß der Erfindung werden, mit anderen Worten ausgedrückt, vorzugsweise unter Anwendung eines IRS-Schreibverfahrens, bei zwei aneinanderstoßenden Gebieten, welche von Lichtquellen im einem ersten beziehungsweise Lichtquellen in einem zweiten Bebilderungsmodul belichtet werden, bzw. bei Zeilen im Übergangsbereich ein Muster von gesetzten Druckpunkten vom ersten Bebilderungsmodul erzeugt, das zum Muster von durch das zweite Bebilderungsmodul gesetzten Druckpunkten disjunkt ist, wobei die Muster eine nicht-einfachzusammenhängende Topologie aufweisen.

Im Besonderen schlägt die Erfindung vor, den Betrag der Relativbewegung in der durch die Achse der Lichtquellen definierten Richtung zwischen den Bebilderungsmodulen und der Druckform größer als den Abstand 1 benachbarter Bildpunkte der n Lichtquellen in jedem Bebilderungsmodul zu wählen und, in Kombination damit, den Betrag der besagten Relativbewegung so zu wählen, dass zwei aneinanderstoßende Zeilen im Übergangsbereich zwischen einem ersten Bereich, dem ein erstes Bebilderungsmodul zugeordnet ist, und einem zweiten Bereich, dem ein zweites Bebilderungsmodul zugeordnet ist, die Menge der in den Übergangsbereich durch das erste Bebilderungsmodul gesetzten Druckpunkte zur Menge der in den Übergangsbereich durch das zweite Bebilderungsmodul gesetzten Druckpunkte komplementär ist, also die insgesamt gesetzten Druckpunkte dicht liegen. Mit anderen Worten: Die Überlagerung des Anfangsrandes der durch das zweite Bebilderungsmodul gesetzten Zeile und des Endrandes der durch das erste Bebilderungsmodul führt im Übergangsbereich zu einer geschlossene Verzahnung der Druckpunkte.

Es ist erwähnenswert, dass eine durchgehende Beschriftung, bei der jeder Druckpunkt genau einmal beschrieben wird, insbesondere dann erreicht werden kann, wenn die Anzahl n der Bildpunkte und ihr Abstand 1, gemessen in Einheiten des Abstandes p der Druckpunkte, keinen gemeinsamen Teiler haben bzw. teilerfremd sind.

Durch Überlagerung des Endrandes der durch das Bebilderungsmodul des ersten Bereichs gesetzten Zeile und des Anfangsrandes der durch das Bebilderungsmodul des zweiten Bereichs gesetzten Zeile wird eine geschlossene Verzahnung der Bildpunkte ermöglicht.

Dadurch wird eine zunächst scharfe Kante zwischen den streifenförmigen Gebieten aufgelöst und der Bandingversatz auf einen größeren Bildbereich verteilt und somit für das Auge eines Betrachters reduziert. Die Erfindung ermöglicht daher in besonders vorteilhafter Weise eine Reduzierung des genannten Banding-Effektes, allerdings ohne eine gleichzeitige Erhöhung des Zeitaufwandes für einen Bebilderungsvorgang.

Es ist hervorzuheben, dass das erfindungsgemäße Verfahren und die Einrichtung zur Bebilderung einer Druckform - neben der vorbeschriebenen Anwendung im Bereich der lasergestützten Bebilderung von Druckformen - entsprechend auch im Bereich verwandter Druck- oder Vervielfältigungsverfahren, beispielsweise im Bereich der Laserdruck-, Tintenstrahldruck- oder auf dem Prinzip der Funkenentladung beruhenden Drucktechniken, sowie der auf dem Xerox-Verfahren oder ähnlichen Verfahren beruhenden Kopiertechniken, oder dergleichen vorteilhaft einsetzbar ist. Denn auch bei diesen Techniken werden Bebilderungsmedien mittels diskreter Bebilderungsquellen zeilenförmig bebildert und somit tritt der vorbeschriebene Effekt des Banding auch dort auf und führt zu den genannten Nebeneffekten, die sich in der Qualität des Druckbildes niederschlagen.

Die Erfindung wird nachfolgend anhand eines zeichnerisch dargestellten Ausführungsbeispiels näher erläutert, aus dem sich weitere Vorteile und Merkmale der Erfindung ergeben. Im Einzelnen zeigen dabei
- Fig. 1: schematisch eine Anordnung eines Bebilderungsmoduls mit einem Array von Lichtquellen mit beispielhaft drei Lichtstrahlen zur Bebilderung einer Druckform;
- Fig. 2: ein Beispiel der Bebilderung einer Zeile im Interleafrasterscanlinien-Verfahren mit einem Bebilderungsmodul, dessen Lichtquellen fünf Bildpunkte erzeugen;
- Fig. 3: eine beispielhafte Einteilung der zu belichtenden Gesamtfläche einer Druckform für vier Bebilderungsmodule in vier zugeordnete Gebiete mit entsprechenden Übergangsbereichen;
- Fig. 4: schematisch die Bebilderung einer zylindrisch ausgebildeten Druckform mittels zweier vorgenannten Bebilderungsmodule, welche die Druckform in jeweils zugeordneten Gebieten und einem Übergangsbereich belichten; und
- Fig. 5: eine schematische Darstellung der erfindungsgemäßen Reduktion des Banding-Effektes.

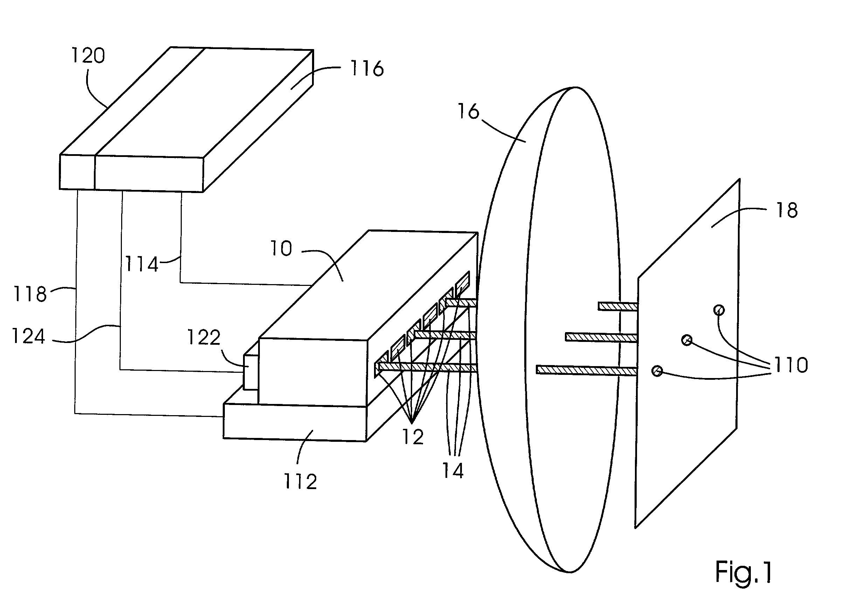

Die aus der deutschen Patentanmeldung Nr. DE 100 31 915 entlehnte Fig. 1 zeigt eine typische Geometrie zur Projektion von n Bildpunkten, welche von einem Array von n Lichtquellen, beispielsweise Laserdioden, in einem Bebilderungsmodul ausgehen, wobei n eine natürliche Zahl ist. Das Bebilderungsmodul 10 besteht beispielsweise aus einem einzeln ansteuerbaren Array von n Einstreifenlaserdioden als Lichtquellen 12, wobei n mit besonderem Vorteil eine Potenz der natürlichen Zahl Zwei ist, also n=2^{k} mit k eine natürliche Zahl. Typischerweise weist eine derartige vorteilhafte Lichtquelle bis zu 100 Einstreifenlaserdioden, vorteilhafterweise zwischen 20 und 70 Laserdioden, auf. Die Einstreifenlaserdioden besitzen Emitterflächen, welche typischerweise 1 x 5 Mikrometer² groß sind, und emittieren Laserstrahlung in vorteilhafter Strahlqualität, mit niedriger Beugungsmaßzahl M². Der Abstand einzelner Laserdioden auf dem Array liegt typischerweise zwischen 100 und 1000 Mikrometern.

Mittels der Abbildungsoptik 16 werden die n Lichtstrahlen auf die n Bildpunkte 110 auf einer Druckform 18 abgebildet. Vorteilhafterweise befindet sich die Druckform 18 in den Foki der Lichtstrahlen 14. Es ist besonders vorteilhaft, dass durch die Abbildungsoptik 16 die Lichtstrahlen sowohl in ihrem Durchmesserverhältnis (senkrecht und parallel zur durch die n Punkte definierten Achse) verändert als auch dass der Abstand der Bildpunkte zueinander korrigiert wird. Mit anderen Worten, sowohl die Fleckgröße der n Bildpunke 110 als auch deren Lage zueinander und deren Abstand sind einstellbar. In der Regel ist der Abstand zwischen den einzelnen Lichtquellen konstant, für eine vorteilhafte Bebilderung ist es aber zumindest erforderlich, dass nur der Abstand 1 der n Bildpunkte 110 konstant ist. Der Abstand 1 der n Bildpunkte ist größer als der Abstand p der Druckpunkte.

Die Lichtquellen 12 des Bebilderungsmoduls 10 können im kontinuierlichen Betrieb eingesetzt werden. Zur Erzeugung einzelner Lichtpakete wird die Laseremission für ein gewisses Zeitintervall entsprechend unterdrückt. In einer besonderen Ausführungsform ist es aber auch möglich, eine Lichtquelle 12 im Bebilderungsmodul 10, welche gepulste Strahlung emittiert, einzusetzen. Bei gepulster Strahlung muss die Repetitionsrate der Lichtimpulse mindestens genauso groß wie die Taktfrequenz zur Erzeugung der einzelnen Druckpunkte sein, so dass wenigstens ein Laserpuls für einen Druckpunkt zur Verfügung steht. Die Abbildungsoptik 16 kann sowohl reflektierende, transmittierende, refraktive oder ähnliche optische Komponenten aufweisen. Bevorzugt handelt es sich dabei um mikrooptische Komponenten. Die Abbildungsoptik 16 kann sowohl eine vergrößernde wie auch verkleinernde als auch in den beiden Richtungen parallel und senkrecht zur aktiven Zone der Laser unterschiedliche Abbildungsmaßstäbe besitzen, welches insbesondere vorteilhaft zur Divergenz- und Aberrationskorrektur ist. Die Oberfläche der Druckform 18 wird in ihren physikalischen oder chemischen Eigenschaften durch die Laserstrahlung verändert. Vorteilhafterweise kommen Druckform zum Einsatz, welche löschbar oder wiederbeschreibbar sind.

In bevorzugter Ausführung befindet sich das Bebilderungsmodul 10 auf einem Kühlelement 112. Das Bebilderungsmodul 10 ist mittels einer Leitung zur Stromversorgung und Steuerung 114 mit einer Steuerungseinheit 116 verbunden. Die Steuerungseinheit 116 weist einzelne Komponenten auf, mit denen es möglich ist, die einzelnen Laserdioden des Arrays der Lichtquellen 12 getrennt voneinander anzusteuern oder zu regeln. Mittels einer Leitung zur Steuerung des Kühlelementes 118 ist das Kühlelement 112 mit der Temperaturregelung 120 verbunden.

Zur Funktionsüberprüfung und Bestimmung der Ausgangsleistung der einzelnen Lichtquellen 12 ist ein Detektor 122 vorgesehen. Der Detektor kann dabei derart ausgeführt sein, dass für jede Lichtquelle eine einzelne Messeinrichtung vorgesehen ist oder aber dass eine Messeinrichtung die einzelnen Lichtquellen im Wechsel oder nach Bedarf überprüft. Vorteilhafterweise ist der Detektor 122 mit der Steuerungseinheit 116 über die Verbindung 124 verknüpft, damit die Ausgangsleistung als ein Parameter zur Generierung eines Regelsignals in der Steuerungseinheit 116 verarbeitet wird.

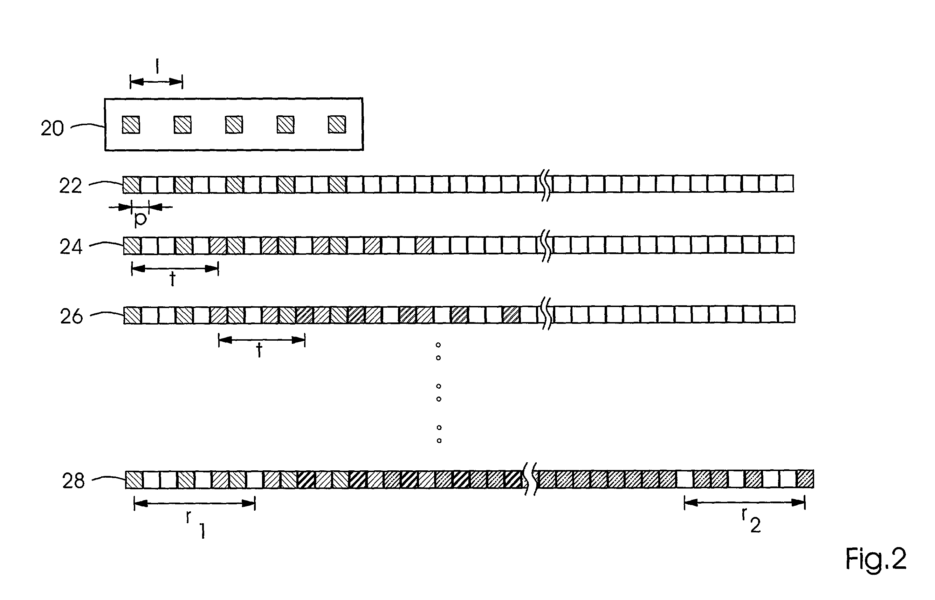

Bevor das IRS-Verfahren anhand eines Beispiels in der Figur 2 näher beschrieben wird, sind allgemeine Erklärungen dazu notwendig. Wie bereits erwähnt, werden zur Bebilderung einer Druckform die Bildpunkte über die Druckfläche zunächst mit einer Komponente senkrecht zu der durch die Linie der Bildpunkte definierten Richtung verschoben, so dass die genannten Rasterscanlinien entstehen. Unter einer zusammenhängenden Zeile von Druckpunkten versteht man dann eine Linie, welche durch die anschließende Verschiebung in der durch die Richtung der Druckpunkte definierten Richtung entsteht und demnach auf gleicher Höhe liegende Druckpunkte verschiedener, nebeneinander geschriebener Scanlinien.

Die Abstände der n Bildpunkte, welche durch die einzelnen n Lichtquellen gleichzeitig erzeugt werden, sind konstant gewählt, vorteilhafterweise ist die Länge 1 zwischen zwei benachbarten Bildpunkten ein ganzzahliges Vielfaches m des Abstandes p der Druckpunkte, d.h. 1 = m x p. Eine durchgehende Beschriftung, bei der jeder Rasterpunkt zumindest einmal vom Bildpunkt einer Lichtquelle berührt wird, mit n gleichzeitig geschriebenen Bildpunkten im Abstand 1 = m x p, wobei m eine natürliche Zahl und p den Abstand der Druckpunkte bezeichnen, ist immer möglich, wenn man eine passende Verschiebung wählt. Die Weite der Verschiebung ist vorteilhafterweise gleich der Anzahl der Bildpunkte.

Es kann dabei jedoch geschehen, dass ein Punkt mehrfach beschriftet wird. Eine durchgehende Beschriftung, bei der jeder Druckpunkt genau einmal geschrieben wird, ist insbesondere dann möglich, wenn die Anzahl der Bildpunkte n, wobei die Schrittweite t = n x p ist, und der Abstand 1 benachbarter Bildpunkte, gemessen in Einheiten des Abstandes p der Druckpunkte, keinen gemeinsamen Teiler haben. Anders ausgedrückt, n und m sind teilerfremd. Dieses ist beispielsweise dann der Fall, wenn m und n unterschiedliche Primzahlen oder Potenzen unterschiedlicher Primzahlen sind. Eine beispielhafte Situation ist also, dass n eine Potenz der natürlichen Zahl Zwei ist und m eine ungerade Zahl. Gleichzeitig ist dann die Verschiebung, welche durch die durch die n Bildpunkte definierte Linie gegebene Richtung festgelegt ist, als n zu wählen. Dabei entsteht am Anfang und am Ende der zu schreibenden Zeile ein Rand von der Größe r: r = n x m - (n + m - 1). Also im in Fig. 2 gezeigten Beispiel: r = 3 x 5 - ( 3 + 5 -1 ) = 8.

Da die einzelnen Lichtquellen einzeln ansteuerbar sind, ist es möglich, jeden Druckpunkt individuell zu gestalten. Die Leistung eines bestimmten Laserstrahls, welcher zur Beschriftung eines Rasterpunktes vorgesehen ist, wird entsprechend der gegebenen Bilddateninformation festgelegt. Damit kann eine individuelle Schwärzung verschiedener Druckpunkte erreicht werden.

Die Fig. 2 illustriert ein in der deutschen Patentanmeldung Nr. DE 100 31 915 offenbartes IRS-Verfahren zum Beschriften von Druckplatten anhand eines Beispiels von fünf Bildpunkten, welche durch die simultane Bestrahlung mit fünf einzelnen Laserdioden gleichzeitig erzeugt werden. Druckpunkte werden in dieser Figur vereinfacht als Kästchen dargestellt. Jeder Druckpunkt muss, wie bereits erwähnt, zumindest einmal von einem Bildpunkt eines Lasers berührt werden, damit er entsprechend den gegebenen Bilddaten belichtet werden oder unverändert gelassen werden kann. Eine zusammenhängende Zeile, welche zu schreiben ist, besteht in diesem Beispiel aus lückenlos aneinander gereihten Druckpunkten. Deren Abstand ist durch p bezeichnet.

In der Fig. 2 besteht die Gruppe von gleichzeitig geschriebenen Druckpunkten eines Bebilderungsmoduls 20 aus fünf Bildpunkten, welche einen gleichmäßigen Abstand 1 aufweisen. In der ersten Bebilderung 22 werden fünf Einheitspunkte mit dem Abstand 1 = 3p geschrieben. Es folgt eine Verschiebung des Bebilderungsmoduls 20 derart, dass die Gruppe von gleichzeitig erzeugten Druckpunkten um fünf Einheitspunkte, da in diesem Beispiel fünf Druckpunkte gleichzeitig geschrieben werden, in die durch die Achse der Druckpunkte definierten Richtung, hier beispielsweise nach rechts.

Im zweiten Bebilderungsschritt 24 werden wieder fünf Bildpunkte nach einer Verschiebung um die Translationsstrecke t gesetzt. In Iteration erfolgt eine erneute Verschiebung um fünf Einheitspunkte in die durch die Achse der Druckpunkte definierten Richtung um die Translationsstrecke t, hier beispielsweise nach rechts. Im folgenden Bebilderungsschritt 26 werden erneut fünf Punkte gesetzt. Aus dieser Sequenz ist ersichtlich, dass die Druckplatte lückenlos beschriftet werden kann: Jeder durch ein Kästchen dargestellte Druckpunkt wird einmal vom Bildpunkt eines Lasers berührt. In jeder erneuten Bebilderung nach einem Verschiebungsschritt um fünf Längeneinheiten als Translationsstrecke t, gemessen in Einheiten von p nach rechts wird stets dasselbe Muster an bereits beschriebenen und noch unbeschriebenen Druckpunkten erzeugt, wie es in 28 ersichtlich ist. Die Zeile von geschriebenen Bildpunkten weist daher an ihrem rechten Ende noch gewisse Lücken mit unbeschriebenen Rasterpunkten auf.

Erfolgt nun eine weitere Bebilderung von fünf Rasterpunkten am rechten Ende dieser Darstellung, so entsteht dieselbe Abfolge von noch unbeschrifteten und bereits beschrifteten Rasterpunkten. Gleichzeitig wird der Anteil der vollständig beschrifteten Druckpunkte der Zeile immer länger.

Im iterierten Bebilderungsschritt 28 ist ebenfalls der Anfangsrand von der Größe r₁ und der Endrand von der Größe r₂, in diesem Fall aus acht Druckpunkten, gemessen in Einheiten des Abstand p der Druckpunkte, ersichtlich. Dabei ist zu betonen, dass die Menge der gesetzten Druckpunkte im Anfangsbereich beziehungsweise im Endbereich eine nicht-einfachzusammenhängende Topologie aufweisen. Gleichzeitig ist in diesem Beispiel zu sehen, dass die geordnete Menge der Druckpunkte, beispielsweise abgezählt von links nach rechts, des Anfangsrandes r₁ ein Muster aufweist, das zu der geordneten Menge der Druckpunkte im Endrand r₂ komplementär ist.

Auch bei Ausfall einzelner Lichtquellen im Array ist es möglich, das vorgeschlagene IRS-Verfahren zum Bebildern von Druckformen zu verwenden. Insbesondere dann, wenn die Anzahl der n Bildpunkte der Laserstrahlen und der Abstand zweier benachbarter Bildpunkte 1, gemessen in Einheiten von p, teilerfremd sind, ist die Bebilderungsgeschwindigkeit maximal. Mit anderen Worten, es ist möglich, eine Schrittweite anzugeben, so dass jeder zu schreibende Punkt nur einmal von einem Bildpunkt der Laserstrahlen berührt wird.

Für den Fall der Funktionsuntüchtigkeit eines oder mehrerer Einstreifenlaserdioden in der Gruppe der gleichzeitig geschriebenen Bildpunkte 30 ist eine Beschriftung mit Hilfe des IRS-Verfahrens immer noch möglich. Dabei wird immer das größte, im gleichen Abstand benachbarte Bildpunkte aufweisende Teilstück der Gruppe zum Beschriften verwendet. Offensichtlich muss dann auch, um eine durchgehende Beschriftung zu erzielen, die Schrittweite reduziert werden. Vorteilhafterweise geschieht das nach den oben aufgestellten Regeln hinsichtlich der Eigenschaften natürlicher Zahlen.

Die Bebilderung einer Druckplatte mit dem IRS-Verfahren ist bei jeder Kombination von Abständen zwischen den benachbarten Bildpunkten 1 und deren Anzahl n möglich. Um eine durchgehende Beschriftung der Druckplatte zu erreichen, sind jedoch geeignete Parameter zu wählen. Bei Ausfall eines Bildpunktes ist eine Bebilderung mit reduzierter Geschwindigkeit möglich.

Für das beschriebene IRS-Verfahren zum Beschreiben einer Druckplatte wird eine Vielzahl von Laserstrahlen benötigt. Diese können auch aus anderen Laserlichtquellen als die vorteilhafterweise einzusetzenden Laserdioden erzeugt werden. Um den projizierten Abstand zwischen den einzelnen Lichtquellen zu verändern, kann in einer vorteilhaften Weiterbildung die Druckplatte gegenüber der senkrecht zu den n Laserstrahlen liegenden Ebene um einen von null verschiedenen Winkel verkippt sein.

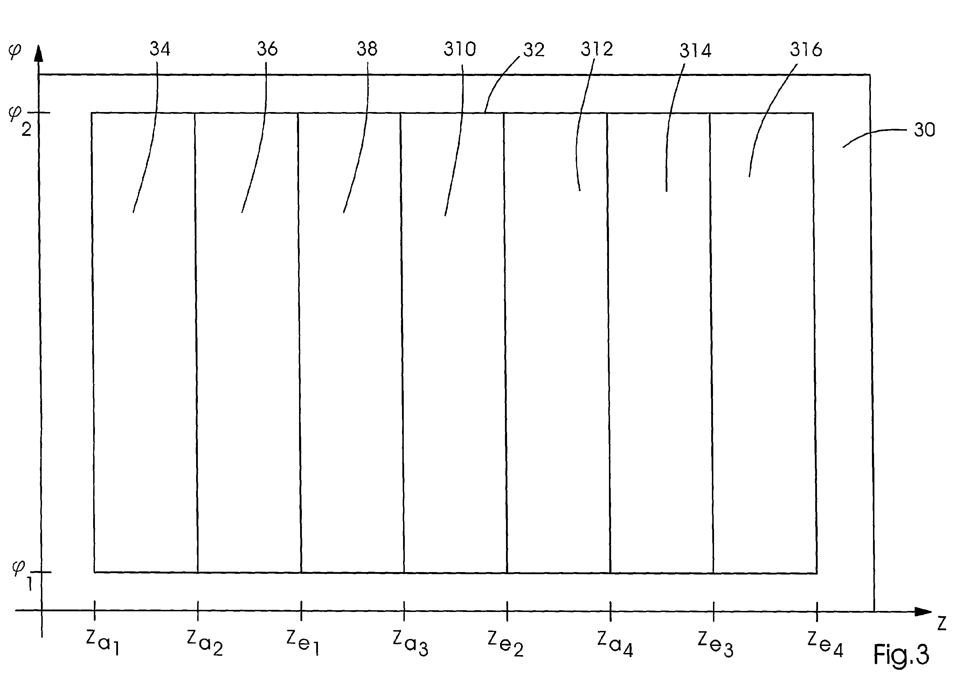

Die Figur 3 zeigt eine beispielhafte Einteilung der zu belichtenden Gesamtfläche einer Druckform für vier Bebilderungsmodule in vier zugeordnete Gebiete mit entsprechenden drei Übergangsbereichen. Die Figur 3 zeigt eine Druckform 30 mit zwei Koordinatenachsen, der Koordinate ϕ und der Koordinate z. Der bildmäßige Bereich 32 der Druckform 30 ist in mehrere streifenförmige, einfach-zusammenhängende Gebiete unterteilt, zwischen denen jeweils Übergangsbereiche liegen. Die Gebiete werden als streifenförmig bezeichnet, da sie eine Ausdehnung von einem Anfang des Streifens bei der Koordinate ϕ₁ bis zu einem Ende des Streifens mit der Koordinate ϕ₂ aufweisen. Das erste Gebiet 34, welchem ein hier nicht gezeigtes erstes Bebilderungsmodul zugeordnet ist, erstreckt sich von einem ersten Anfangspunkt za, bis zu einem zweiten Anfangspunkt za₂. Das erste Gebiet 34 wird durch das hier nicht gezeigte erste Bebilderungsmodul belichtet. Es schließt sich ein erster Übergangsbereich 36, welcher sich vom zweiten Anfangspunkt za₂ bis zum ersten Endpunkt ze₁ erstreckt, an. Es folgt ein zweites Gebiet 38, welches sich vom ersten Endpunkt ze₁ bis zum dritten Anfangspunkt za₃ erstreckt. Diesem zweiten Gebiet ist ein hier nicht gezeigtes zweites Bebilderungsmodul zugeordnet. Das zweite Gebiet 38 wird durch das hier nicht gezeigte zweite Bebilderungsmodul belichtet. Der erste Übergangsbereich 36 wird sowohl vom hier nicht gezeigten ersten Bebilderungsmodul als auch vom hier nicht gezeigten zweiten Bebilderungsmodul belichtet. In analoger Fortsetzung schließt sich an das zweite Gebiet 38 ein zweiter Übergangsbereich 310 an, welcher sich vom dritten Anfangspunkt za₃ bis zum zweiten Endpunkt ze₂ erstreckt. Mit anderen Worten: Das hier nicht gezeigte erste Bebilderungsmodul kann derart bewegt werden, dass die Bildpunkte seiner Lichtquellen sowohl im ersten Gebiet 34 als auch im ersten Übergangsbereich 36 liegen können, so dass eine Bebilderung durch Translation in Längsrichtung und in Querrichtung des streifenförmigen, einfach-zusammenhängenden ersten Gebietes 34 und des streifenförmigen, einfach-zusammenhängenden ersten Übergangsbereichs 36 vorgenommen werden kann. Gleichzeitig kann das hier nicht gezeigte zweite Bebilderungsmodul derart bewegt werden, dass die Bildpunkte seiner zugehörigen Lichtquellen sowohl im ersten Übergangsbereich 36 als auch im zweiten Gebiet 38 als auch im zweiten Übergangsbereich 310 liegen können. An den zweiten Übergangsbereich 310 schließt sich ein drittes Gebiet 312 mit den Grenzen des zweiten Endpunktes ze₂ und dem vierten Anfangspunkt za₄ an. Es folgt ein dritter Übergangsbereich 314 mit den Grenzen des vierten Anfangspunktes za₄ und des dritten Endpunktes ze₃. Des weiteren ist ein viertes Gebiet 316 zu sehen, welches sich vom dritten Endpunkt ze₃ bis zum vierten Endpunkt ze₄ erstreckt. In Analogie zum ersten Gebiet 34, ersten Übergangsbereich 36 und zweitem Gebiet 38 und den zugehörigen hier nicht gezeigten ersten und zweiten Bebilderungsmodulen sind hier nicht gezeigte dritte und vierte Bebilderungsmodule vorgesehen. Die Bildpunkte des dritten hier nicht gezeigten Bebilderungsmoduls können dabei im zweiten Übergangsbereich 310, im dritten Gebiet 312 und im vierten Übergangsbereich 314 liegen, während die Bildpunkte der Lichtquellen des vierten hier nicht gezeigten Bebilderungsmoduls im vierten Übergangsbereich 314 und im vierten Gebiet 316 liegen können.

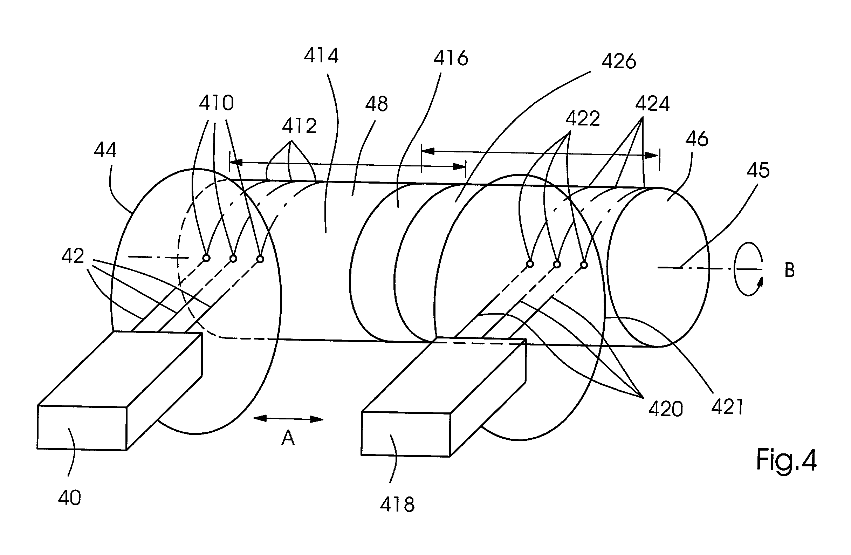

In der Fig. 4 wird die Bebilderung einer Druckform, welche sich auf einem rotierbaren Zylinder befindet, gezeigt, wie beispielhaft ein erstes Bebilderungsmodul 40 und ein zweites Bebilderungsmodul 418 verwendet werden. Die Druckform ist dabei in ein erstes Gebiet 414, einen Übergangsbereich 416 und ein zweites Gebiet 426 eingeteilt.

Das erste Bebilderungsmodul 40 erzeugt n Lichtstrahlen, hier beispielhaft drei Lichtstrahlen 42, welche mittels der ersten Abbildungsoptik 44 auf drei Bildpunkte 410 abgebildet werden. Vorteilhafterweise haben die drei Bildpunkte einen gleichmäßigen Abstand und liegen auf einer Achse. Die Druckform 48 befindet sich auf einem Zylinder 46, welcher um seine Symmetrieachse 45 drehbar ist. Diese Drehung ist durch den Pfeil B bezeichnet. Das Bebilderungsmodul 40 kann parallel zur Symmetrieachse 45 des Zylinders 46 auf linearem Wege bewegt werden, welches mit dem Doppelpfeil A gekennzeichnet ist. Das erste Bebilderungsmodul 40 kann dabei derart bewegt werden, dass die zugeordneten Bildpunkte 410 im ersten Gebiet 414 und/oder im Zwischenbereich 416 liegen.

Das zweite Bebilderungsmodul 418 erzeugt n Lichtstrahlen, hier beispielhaft drei Lichtstrahlen 420, welche mittels der zweiten Abbildungsoptik 421 auf drei Bildpunkte 422 abgebildet werden. Vorteilhafterweise haben die drei Bildpunkte 422 einen gleichmäßigen Abstand, bevorzugt denselben wie die Bildpunkte 410 des ersten Bebilderungsmoduls 40, und liegen auf einer Achse. Das zweite Bebilderungsmodul 418 kann parallel zur Symmetrieachse 45 des Zylinders 46 auf linearem Wege bewegt werden, welches mit dem Doppelpfeil A gekennzeichnet ist. Das zweite Bebilderungsmodul 418 kann dabei derart bewegt werden, dass die zugeordneten Bildpunkte 422 im zweiten Gebiet 426 und/oder im Zwischenbereich 416 liegen.

Zur kontinuierlichen Bebilderung rotiert der Zylinder 46 mit der Druckplatte 48 gemäß der Rotationsbewegung B, und das erste Bebilderungsmodul 40 und das zweite Bebilderungsmodul 418 translatieren längs des Zylinders 46 gemäß der Bewegungsrichtung A. Die Vorschubgeschwindigkeit wird durch die Anzahl der Lichtstrahlen 42 bzw. Lichtstrahlen 420 und die Breite p eines Druckpunktes bestimmt. Es ergibt sich eine Bebilderung, welche auf schraubenförmigem Wege die Symmetrieachse 45 des Zylinders 46 umläuft. Der Weg der ersten Bildpunkte 410 ist durch die Linien 412 und der Weg der zweiten Bildpunkte 422 durch die Linien 424 angedeutet. Nach erfolgter Bebilderung von n Punkten erfolgt demnach eine relative Verschiebung von Druckform 48 und Bildpunkten 410 bzw. Bildpunkten 422 jeweils mit einer Vektorkomponente senkrecht zu der durch die Linie der n Bildpunkte 410 bzw. Bildpunkte 422 definierten Richtung um einen ersten bestimmten Betrag, so dass an einer anderen Stelle der Druckplatte 48 erneut n Punkte geschrieben werden. Dadurch entstehen sogenannte "Rasterscanlinien" von Bildpunkten. Zu jedem bestimmten Abstand benachbarter Rasterscanlinien und Anzahl n der Bildpunkte ergibt sich ein zweiter bestimmter Betrag einer notwendigen Verschiebung parallel zu der durch die Linie der n Bildpunkte definierten Achse, so dass eine kontinuierliche Bebilderung, d.h. die Bebilderung jedes vorgesehenen Rasterpunktes auf der Druckform 48, mit einem nachfolgend noch eingehender beschriebenen Interleafrasterscanlinien-Verfahren (im Folgenden "IRS-Verfahren") möglich ist.

In einem alternativen Ausführungsbeispiel können die Bildpunkte 410 auch mäanderförmig über die Druckform 48 bewegt werden, indem zunächst eine vollständige Bebilderung entlang einer Linie parallel zur Symmetrieachse 45 des Zylinders 46 und anschließend eine schrittweise Rotation um diese Symmetrieachse 45 ausgeführt wird.

Es versteht sich, dass es nur auf eine relative Bewegung zwischen den Bildpunkten 410 und der Druckplatte 48 ankommt. Diese Relativbewegung kann auch durch eine Bewegung des Druckzylinders 46 erreicht werden. Für beide Bewegungsrichtungen der Translation A und der Rotation B gilt, dass die Bewegungen kontinuierlich oder schrittweise erfolgen können.

Des Weiteren kann wenigstens ein Bebilderungsmodul, beispielsweise das erste Bebilderungsmodul 40, die Lichtquelle 42, die Abbildungsoptik 44 und dergleichen aufweisend, alternativ auch innerhalb des Druckzylinders 46 ausgeführt sein, so dass eine platzsparende Anordnung erreicht wird.

Eine derartiges Bebilderungseinrichtung mit mehreren Bebilderungsmodulen kann einzeln oder mehrfach innerhalb oder außerhalb eines Druckformbelichters, eines Druckwerkes oder einer Druckmaschine verwirklicht werden.

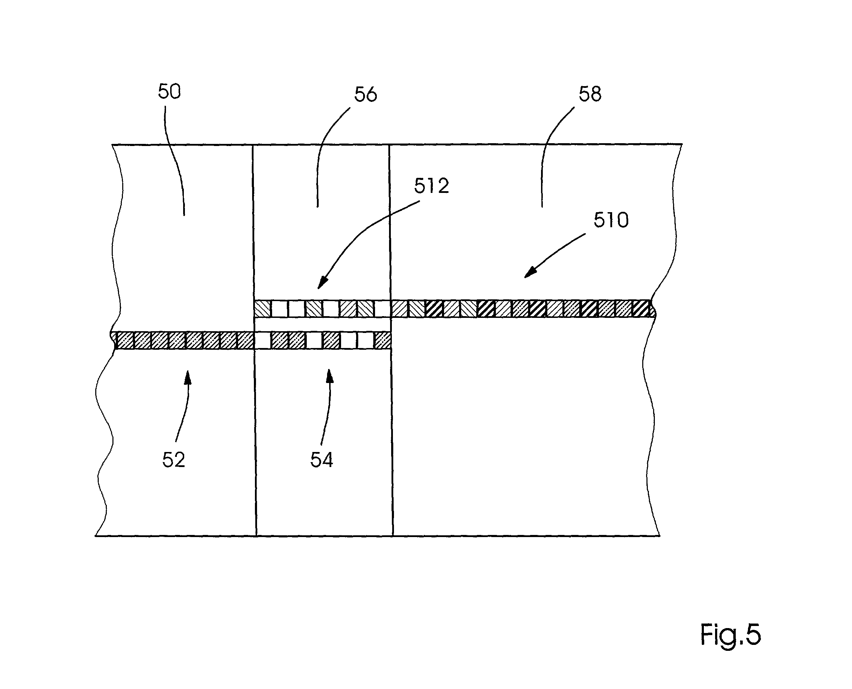

Anhand von Fig. 5 soll nun die erfindungsgemäße Reduktion des Banding-Effektes verdeutlicht werden. Die Fig. 5 zeigt schematisch ein erstes Gebiet 50, in welchem eine Druckpunktzeile des ersten zugeordneten Bebilderungsmoduls 52 liegt, einen Übergangsbereich 56, in welchem der Endrand 54 der Druckpunktzeile des ersten Bebilderungsmoduls und der Anfangsrand 512 der Druckpunktzeile des zweiten Bebilderungsmoduls liegen, und ein zweites Gebiet 58, in welchem eine Druckpunktzeile des zweiten Bebilderungsmoduls 510 liegt. Nur zur besseren Veranschaulichung ist in der Fig. 5 die Druckpunktzeile des ersten Bebilderungsmoduls 52 zur Druckpunktzeile des zweiten Bebilderungsmoduls 510 in senkrechter Richtung zur Achse der Bildpunkte beabstandet gezeichnet.

Der bereits genannte Übergangsbereich 56 erstreckt sich in diesem beispielhaften Fall über acht Druckpunkte, dem bespielhaften Fall in Figur 2 entsprechend einer Bebilderung mit fünf Bildpunkten im benachbarten Abstand 1=3p und einer Verschiebung um die Translationsstrecke t=5p, wobei p den Abstand der Druckpunkte bezeichnet.

Der vom ersten Bebilderungsmodul gesetzte Endrand 54 weist dabei eine Menge von nicht-einfachzusammenhängenden gesetzten Druckpunkten auf, und der vom zweiten Bebilderungsmodul gesetzte Anfangsrand 512 eine Menge von nicht-einfachzusammenhängenden gesetzten Druckpunkten, welche zur Menge des Endrands 54 komplementär ist.

Nun werden durch die Druckpunktzeile des ersten Bebilderungsmoduls 510 im Endrandbereich 54 Ortslagen im Übergangsbereich 56 vorgegeben, an denen noch Druckpunkte zwischen die bebilderten Druckpunkte zu setzten sind. Aufgrund von häufig justagebedingten Abweichungen wird im allgemeinen das zweite Bebilderungsmodul nicht exakt an diese Orte Druckpunkte setzen, es gibt einen Versatz oder eine Abweichung. Durch Ineinanderschreiben, d.h. in der vorliegenden Darstellung in Flucht bringen der beiden, in der Realität aneinanderstoßenden Zeilen entsteht für das Auge ein "kontinuierlicher" Übergangsbereich, der nicht durch einen abrupten Wechsel bestimmt ist. Der Versatz wird auf den Übergangsbereich 56 verteilt. Des Weiteren existieren keine räumlichen Muster, die das menschliche Auge sehr leicht detektieren kann, da die Verteilung der Punktzeilen, insbesondere bei Verwendung einer großen Anzahl von Schreibkanälen, z. B. anstatt der oben beschriebenen fünf gleichzeitig beschriebenen Bildpunkte fünfzig gleichzeitig beschriebene Bildpunkte, für das Auge nicht einfach nachvollziehbar ist und der Übergangsbereich 56 der Breite des Schreibbereiches, z.B. 1 cm, entspricht.

Durch das erfindungsgemäße Verfahren und den Einsatz von mehreren Bebilderungsmodulen in der erfindungsgemäßen Einrichtung wird eine zunächst scharfe Kante zwischen den streifenförmigen ersten Gebiet 50 und zweiten Gebiet 58 aufgelöst, und ein Versatz beziehungsweise eine Justageabweichung zwischen dem ersten und dem zweiten Bebilderungsmodul, welche zu einer Abweichung der Lage der vom zweiten Bebilderungsmodul gesetzten Druckpunkte im Anfangsbereich 512 von der vorgesehen Lage eines noch nicht gesetzten Druckpunktes im Endbereich 54 führt, auf einen größeren Bildbereich, dem Übergangsbereich 56 entsprechend, verteilt und somit für das Auge eines Betrachters reduziert. Die Erfindung ermöglicht daher in besonders vorteilhafter Weise eine Reduzierung des genannten Banding-Effektes.

Im Gegensatz zum Stand der Technik wird dieser Übergangsbereich bei vorzugweiser Verwendung eines Interleafverfahrens nicht durch eine zusätzliche Bebilderung erreicht und führt somit nicht zu einer Verlängerung der Bebilderungszeit, da die Musterbildung des Anfangsrandes und des Endrandes ausgenutzt wird.

Auch bei Bebilderungsmodulen, welche die Druckpunkte dicht bebildern, siehe beispielsweise US 5,818,498, kann der Banding-Effekt ebenfalls mit diesem Verfahren reduziert werden. Dazu müssen jedoch die Übergangsbereiche dadurch erzeugt werden, dass nicht alle Punkte von einem Bebilderungsmodul geschrieben werden. Vorteilhaft ist in diesem Fall, dass auch eine zufällige Verteilung der einzelnen Bildpunkte auf die zu bebildernden Medien möglich ist und somit der Reduktionseffekt sogar noch verstärkt wird.

### Bezugszeichenliste

- 10: Bebilderungsmodul
- 12: Lichtquelle
- 14: Lichtstrahl
- 16: Abbildungsoptik
- 18: Druckform
- 110: Bildpunkt
- 112: Kühlelement
- 114: Leitung zur Stromversorgung und Steuerung
- 116: Steuerungseinheit
- 118: Leitung zur Temperaturregelung
- 120: Temperaturregelung
- 122: Detektor zur Funktionsüberprüfung und Leistungsmessung
- 124: Verbindung zur Steuerung
- 20: gleichzeitig geschriebene Druckpunkte eines Bebilderungsmoduls
- 22: erste Bebilderung
- 24: zweite Bebilderung
- 26: dritte Bebilderung
- 28: iterierte Bebilderung
- 1: Abstand benachbarter Bildpunkte
- p: Abstand benachbarter Druckpunkte
- n: Anzahl der Bildpunkte
- r₁: Anfangsrand
- r₂: Endrand
- t: Translationsstrecke
- ϕ: Koordinate in Streifenrichtung
- z: Koordinate in Interleaving-Richtung
- ϕ₁: Anfang des Streifens
- ϕ₂: Ende des Streifens
- za₁: erster Anfangspunkt
- za₂: zweiter Anfangspunkt
- ze₁: erster Endpunkt
- za₃: dritter Anfangspunkt
- ze₂: zweiter Endpunkt
- za₄: vierter Anfangspunkt
- ze₃: dritter Endpunkt
- ze₄: vierter Endpunkt
- 30: Druckform
- 32: bildmäßiger Bereich
- 34: erstes Gebiet
- 36: erster Übergangsbereich
- 38: zweites Gebiet
- 310: zweiter Übergangsbereich
- 312: drittes Gebiet
- 314: dritter Übergangsbereich
- 316: viertes Gebiet
- 40: erstes Bebilderungsmodul
- 42: Lichtstrahlen
- 44: erste Abbildungsoptik
- 45: Symmetrieachse
- 46: Zylinder
- 48: Druckform
- 410: Bildpunkte des ersten Bebilderungsmoduls
- 412: Weg der ersten Bildpunkte
- 414: erstes Gebiet
- 416: Übergangsbereich
- 418: zweites Bebilderungsmodul
- 420: Lichtstrahlen
- 421: zweite Abbildungoptik
- 422: Bildpunkte des zweiten Bebilderungsmoduls
- 424: Weg der zweiten Bildpunkte
- 426: zweites Gebiet
- A: Translation
- B: Rotation
- 50: erstes Gebiet
- 52: Druckpunktzeile des ersten Bebilderungsmoduls
- 54: Endrand
- 56: Übergangsbereich
- 58: zweites Gebiet
- 510: Druckpunktzeile des zweiten Bebilderungsmoduls
- 512: Anfangsrand

## Patentansprüche

1. Verfahren zur Bebildung einer Druckform (48) durch wenigstens ein erstes Bebilderungsmodul (40) und ein zweites Bebilderungsmodul (418) zur Erzeugung von Druckpunkten auf der Druckform (48), wobei beide Bebilderungsmodule (40,418) zur Bebilderung in einem Übergangsbereich (416) gleiche Orte der Druckform (48) überstreichen,
**gekennzeichnet durch:**
- Erzeugung im Übergangsbereich (416) einer Anzahl von wenigstens teilweise nicht-einfachzusammenhängenden Druckpunkten **durch** das erste Bebilderungsmodul (40) und Erzeugung der komplementären, nicht-einfachzusammenhängenden Druckpunkte **durch** das zweite Bebilderungsmodul (418).

2. Verfahren zur Bebildung einer Druckform (48) gemäß Anspruch 1,
**gekennzeichnet durch:**
- Zuordnung von wenigstens einem einfachzusammenhängenden ersten Gebiet (414) der Druckform (48) zum ersten Bebilderungsmodul (40) und einem zweiten einfachzusammenhängenden Gebiet (426) der Druckform (48) zum zweiten Bebilderungsmodul (418), wobei die Druckpunkte im jeweiligen Gebiet nur vom ihm zugeordneten Bebilderungsmodul erzeugt werden.

3. Verfahren zur Bebildung einer Druckform gemäß Anspruch 2,
**gekennzeichnet durch:**
- Verwendung von Bebilderungsmodulen (10), welche n Lichtquellen (12) aufweisen, deren Bildpunkte (110) auf der Druckform (18) einen Abstand 1 benachbarter Bildpunkte aufweisen, wobei 1 ein Vielfaches des Abstandes p zweier benachbarter Druckpunkte ist.

4. Verfahren zur Bebildung einer Druckform (48) gemäß Anspruch 3,
**gekennzeichnet durch:**
- Belichtung der Druckform **durch** jedes Bebilderungsmodul (40, 418) wenigstens im Übergangsbereich (416) mit einem Interleafverfahren.

5. Verfahren zur Bebildung einer Druckform (48) gemäß Anspruch 4,
**gekennzeichnet durch:**
- Verwendung eines Interleafverfahrens mit einer Schrittweite t gleich der Anzahl n der Lichtquellen (12) in jedem der Bebilderungsmodule (10), wobei die Schrittweite t und der Abstand 1 benachbarter Bildpunkte, gemessen in Einheiten p des Abstandes benachbarter Druckpunkte, teilerfremd sind.

6. Einrichtung zur Bebildung einer Druckform (48) durch wenigstens zwei Bebilderungsmodule (40, 418), welche relativ zu der Druckform (48) bewegbar sind, wobei die Bewegung des ersten Bebilderungsmodul (40) die Bildpunkte wenigstens einer Lichtquelle (410) und die Bewegung des zweiten Bebilderungsmoduls (418) die Bildpunkte wenigstens einer Lichtquelle (422) über einen Übergangsbereich (416) der Druckform führt, so dass Druckpunkte durch eine einmalige Passage eines Bildpunktes (410, 422) einer Lichtquelle erzeugt werden,
**dadurch gekennzeichnet,**
**dass** die Bildpunkte (410) der Lichtquellen des ersten Bebilderungsmoduls (40) im Übergangsbereich (416) eine Menge von Druckpunkten erzeugen, welche eine nicht-einfachzusammenhängende Menge bilden, und die Bildpunkte (422) der Lichtquellen des zweiten Bebilderungsmoduls (418) im Übergangsbereich (416) die komplementäre, nicht-einfachzusammenhängende Menge von Druckpunkten erzeugen.

7. Einrichtung zur Bebildung einer Druckform durch wenigstens zwei Bebilderungsmodule (40,418) gemäß Anspruch 6,
**dadurch gekennzeichnet,**
**dass** jedes Bebilderungsmodul (40,418) n Lichtquellen, welche im wesentlichen auf einer Linie mit einem Abstand 1 zwischen benachbarten Lichtquellen liegen, aufweist.

8. Druckformbelichter,
**dadurch gekennzeichnet,**
**dass** der Druckformbelichter wenigstens eine Einrichtung zur Bebilderung einer Druckform gemäß Anspruch 6 oder Anspruch 7 aufweist.

9. Druckwerk,
**dadurch gekennzeichnet,**
**dass** das Druckwerk wenigstens eine Einrichtung zur Bebilderung einer Druckform gemäß Anspruch 6 oder Anspruch 7 aufweist.

10. Druckmaschine,
**dadurch gekennzeichnet,**
**dass** die Druckmaschine wenigstens ein Druckwerk gemäß Anspruch 9 aufweist.
